# EUROPEAN PATENT SPECIFICATION

(11) **EP 1 705 204 B1**
(45) Date of publication and mention of the grant of the patent: **21.04.2010**
(21) Application number: 06075335.7
(22) Date of filing: 14.02.2006
(51) Int. Cl.: C08G 73/00

(54) **Photosensitive resin and a method of preparing the same**
Photosensitives Harz und Verfahren deren Herstellung
Résin photosensitive et procédé de préparation

(30) Priority: 14.02.2005 JP 2005036394; 08.02.2006 JP 2006031084
(43) Date of publication of application: 27.09.2006
(73) Proprietor: Shin-Etsu Chemical Co., Ltd., Tokyo 100-0004 (JP)
(72) Inventor: Aoki, Yoshitaka 1-10 Oaza Hitomi, Gunma, 379-0224 (JP); Sugo, Michihiro 1-10 Oaza Hitomi, Gunma, 379-0224 (JP); Kato, Hideto 1-10 Oaza Hitomi, Gunma, 379-0224 (JP)
(74) Representative: Winckels, Johannes Hubertus F.

(56) References cited:
- EP-A- 0 402 141
- EP-A- 0 459 395
- EP-A- 0 997 777

## Description

### FIELD OF THE INVENTION

The present invention relates to a photosensitive polyimide resin, specifically to a polyimide resin having 1,2-naphthoquinonediazidosulfonyl group and a polysiloxane group, a composition comprising the resin and a method of preparing the resin. The polyimide resin is suitable for use as a positive photoresist and to make a protective film.

### DESCRIPTION OF THE PRIOR ART

Photosensitive polyimide materials comprising precursors thereof, i.e., polyamic acids, are known. For example, Japanese Patent Application (JPA) Laid-Open No.49-115541, JPA Laid-Open No. 55-45746 describe polyamic acids having photosensitive groups introduced by esterifying carboxyl group, and JPA Laid-Open No. 54-145794 describes a photosensitive material comprising a polyamic acid and amine compound having a photosensitive group. These materials need to be imidized at a temperature above 300 °C after being applied and patterned on a substrate to from a polyimide film, which restricts usable substrates or oxidizes copper circuits provided on the substrate.

To avoid the imidization at a high temperature, a photosensitive polyimide resin soluble in a solvent is known from JPA Laid-Open No. 10-274850, JPA Laid-Open No. 10-265571, and JPA Laid-Open No. 13-335619. All of the polyimide resins have (meth)acryl group as a photosensitive group. Photopolymerization of the (meth)acrly group tends to be inhibited with oxygen, so that residual film ratio, i.e., ratio of film thickness after a development process to original film thickness, is not so high, and its resolution is difficult to improve.

Meanwhile, a polyimide resin having phenolic hydroxyl groups is known from JPA Laid-Open No. 3-209478, and a positive photoresist composition comprising a polyimide and diazonaphthoquinone is known from Japanese Patent Publication No. 1-46862 and JPA Laid-Open No. 11-65107. Cured films thereof, however, fail to have characteristics of polyimide due to a relative low molecular weight or relatively larger amount of diazonaphthoquinone. Further, residual film ratio of the positive photoresist composition is not so high.

EP-A-0 997 777 discloses a positive-type, heat-resistant photosensitive polymer composition comprising (a) a polyimide precursor or a polyimide which is soluble in an aqueous alkaline solution, (b) a compound capable of generating an acid when exposed to light, and (c) a compound having a phenolic hydroxyl group. The polyimide component (a) neither contains a 1,2-naphthoquinonediazide sulfonyl group nor a polysiloxane group.

EP-A-0 459 395 describes a photo-sensitive resin composition comprising a polybenzoxazole precursor as a base resin an organic solvent-soluble polymer or its precursor (e. g., a polyamic acid) as a component for imparting improved adhesion, flexibility or heat resistance, and a diazoquinone compound and/or a dihydropyridine compound as a photo-sensitive agent. The photo-sensitive resin does not comprise a polyimide that contains a 1,2-naphthoquinonediazide sulfonyl group.

EP-A-0 402 141 discloses a photosensitive alkali-soluble, thermally stable fluorinated hydroxyl-resinous polyimide composition comprising a resin-bound diazo sensitizer incorporated by the reaction of a diazo sensitizer compound with a predetermined percentage of the hydroxyl groups of the hydroxyl-resin binder. The polyimide composition does not comprise a polyimide polymer containing a polysiloxane group.

### SUMMARY OF THE INVENTION

An object of the present invention it to provide a photosensitive polyimide resin which shows high residual film ratio, adhesion strength and electrical insulation and a method of preparing the same.
The present invention provides a polyimide resin having a number average molecular weight of from 2,000 to 800,000, said resin consisting of the three repeating units represented by the following formula (3): 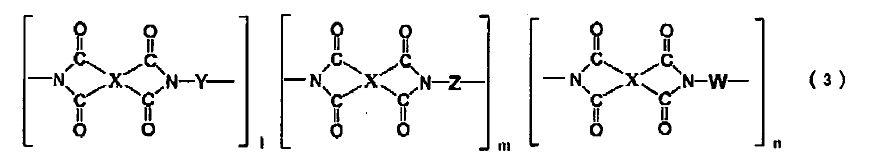 wherein X is a tetravalent organic group,
Y is a divalent organic group represented by the following formula (2): 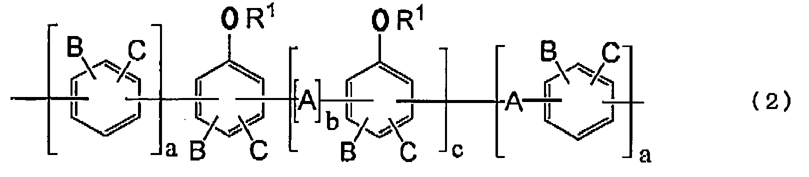 wherein A may be the same as or different from each other and is a divalent organic group selected from the following groups: 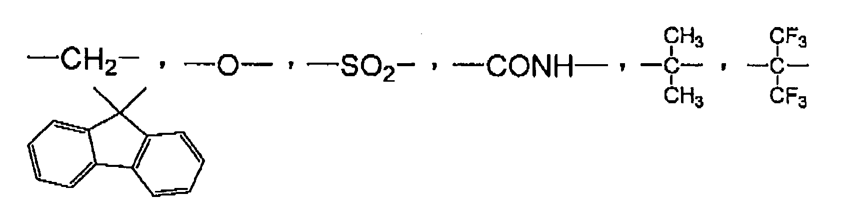 B and C may be the same or different from each other and are selected from the group consisting of a hydrogen atom and alkyl groups having 1 to 4 carbon atoms, a is 0 or 1, c is an integer of from 0 to 10, b is 0 or 1, 75 to 98 mole % of R¹ is a hydrogen atom, and 2 to 25 mole % of R¹ is 1,2-naphthoquinonediazide sulfonyl group,
W is a divalent organic group represented by the following formula (5): 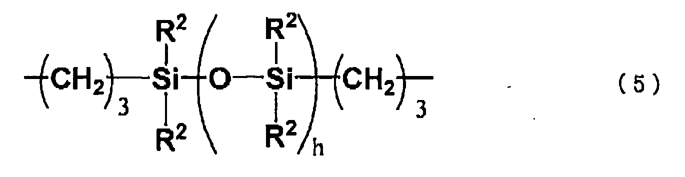 wherein R² may be the same as or different from each other and is a monovalent hydrocarbon group having 1 to 8 carbon atoms and h is an integer of from 5 to 50,
Z is a divalent organic group other than Y and W,
l is a positive integer, and m and n are integers of 0 or larger with 0.1 ≤ l/(l+m+n) <1, 0 < m/(l+m+n)≤ 0.8, and 0 < n/(l+m+n) ≤ 0.8.

Further aspects of the present invention include a method of preparing the aforementioned polyimide resin, a photosensitive composition comprising the same, and a method of forming a patterned layer, as respectively defined in appended claims 6, 7 and 8.

### DESCRIPTION OF THE PREFERRED EMBODIMENTS

The present polyimide resin is characterized by having the three repeating units represented by the aforesaid formula (3). In formula (3), Y is represented by the following formula (2): 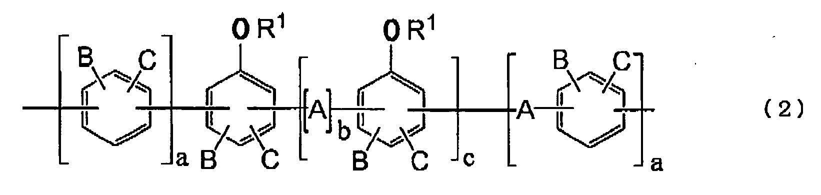 wherein B and C are independently selected from the group consisting of a hydrogen atom, methyl, ethyl, propyl, and butyl groups, among which a hydrogen atom and a methyl group are preferred because of good availability of raw materials thereof.

In the formula (2), from 75 to 98 mole %, preferably from 80 to 95 mole % of R¹ is a hydrogen atom and from 2 to 25 mole %, preferably from 5 to 20 mole % of R¹ is 1,2-naphthoquinonediazide sulfonyl group represented by any one of the following formulas:

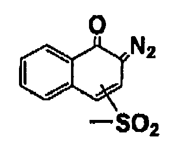

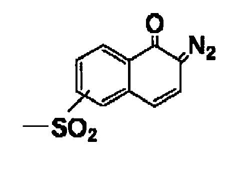

A polyimide resin having 1,2-naphthoquinonediazide sulfonyl group more than the aforesaid upper limit may become after stored too viscous to handle due to decomposition of the diazido group, depending on its concentration and a storing temperature. A resin having 1,2-naphthoquinonediazide sulfonyl groups less than the aforesaid lower limit may have low residual film ratio and, consequently, is not suitable as a photosensitive resin.

Preferably, 1,2-naphthoquinonediazide sulfonyl group is 1,2-naphthoquinonediazide-4-sulfonyl group and/or 1,2-naphthoquinonediazide-5-sulfonyl group.

In the aforesaid formula (3), Y is a divalent organic group. Examples of Y are as shown below: 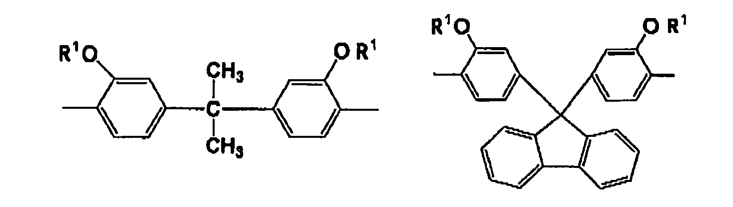 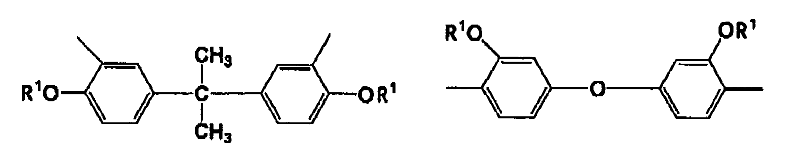 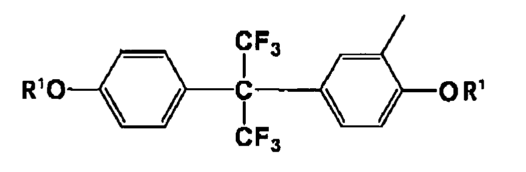 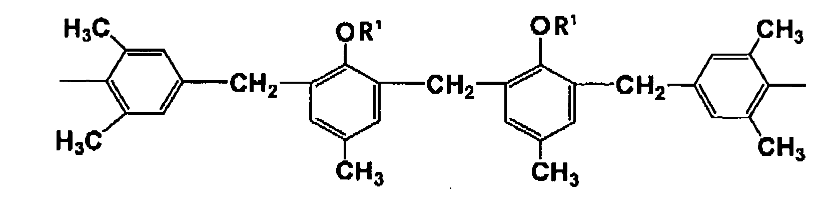 wherein R¹ is as defined above.

Suitably in the formula (3), X can be selected from the following groups:

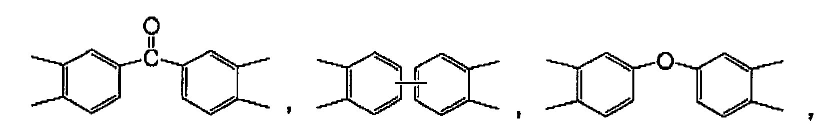

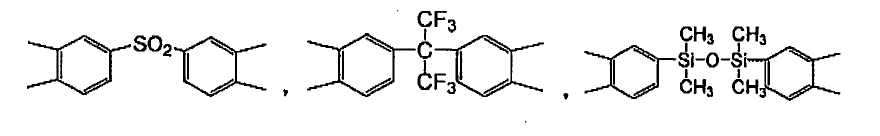

In the formula (3), X may be derived from an acid dianhydride. Examples of the acid dianhydride include 3,3',4,4'-diphenylsulphonetetracarboxylic dianhydride, 3,3',4,4'-biphenyltetracarboxylic dianhydride, 2,3',3,4'-biphenyltetracarboxylic dianhydride, 5-(2,5-dioxotetrahydro-3-furunyl)-3 methyl-3-cyclohexene-1,2-dicarboxyl dianhydride, 4-(2,5-dioxotetrahydrofuran-3-yl)-1,2,3,4-tetrahydronaphthalene-1,2-dicarboxylic dianhydride, 1,2,3,4-butanetetracarboxylic dianhydride, 3,3',4,4'-benzophenonetetracarboxylic dianhydride, 4,4'-hexafluoropropylidenebisphthalic dianhydride, 2,2-bis(p-trimethoxyphenyl)propane, 1,3-tetramethyldisiloxanebisphthalic dianhydride, and 4,4'-oxydiphthalic dianhydride, among which 4,4'-hexafluoropropylidenebisphthalic dianhydride and 4,4'-oxydiphthalic dianhydride are preferred.

A number average molecular weight of the polyimide resin ranges from 2,000 to 800,000, preferably from 5, 000 to 500, 000. A polyimide resin having a molecular weight less than the aforesaid lower limit may give a cured film having undesirably low mechanical strength. On the other hand, a polyimide resin having a molecular weight above the aforesaid upper limit may have undesirably low compatibility with a solvent.

In formula (3):

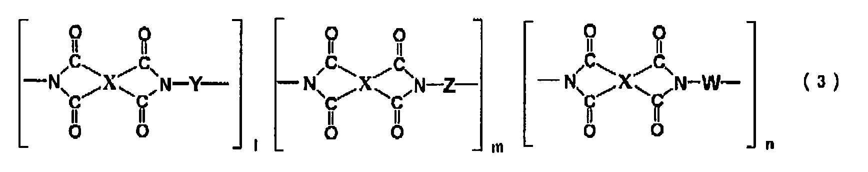

W is a divalent organic group represented by formula (5) described herein below, Z is a divalent organic group other than Y and W, l is a positive integer, m and n are integers of 0 or larger with 0.1 ≤ l/(l+m+n) < 1, preferably 0.2 ≤ l/(l+m+n)≤0.9, 0<m/(l+m+n)<0.8, preferably 0<m/(l+m+n)≤ 0.5, 0 <n/(l+m+n)≤ 0.8, preferably 0<n/(l+m+n)≤0.5. The numbers, l, m, n are so selected that the polyimide resin has the aforesaid molecular weight. Typically, l ranges from 2 to 2000, m and n range from 0 to 2000. A polyimide resin with l/(l+m+n) being less than the aforesaid lower limit has too low photosensitivity.

Preferably, Z is represented by the following formula (4): 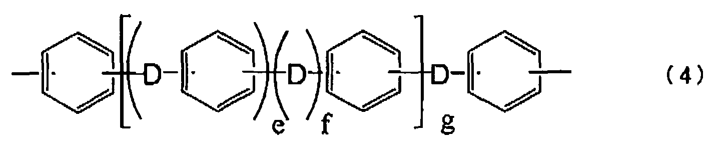 wherein D may be the same as or different from each other and is a divalent organic group selected from the following groups,

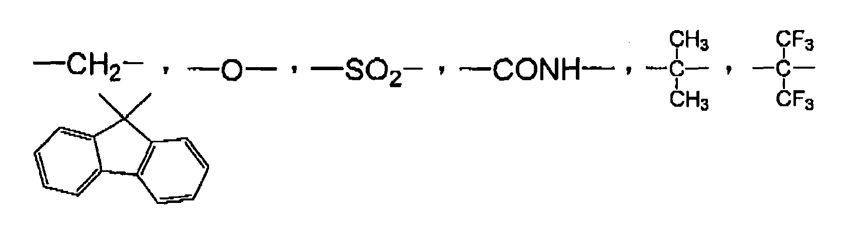

In the formula (4), g is 0 or 1, and e and f are 0 or 1.

Examples of Z are as shown below:

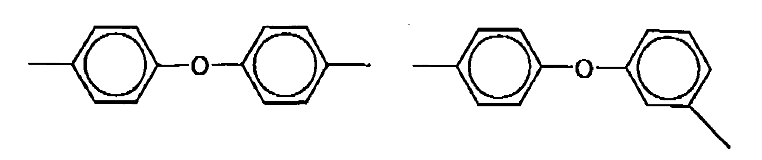

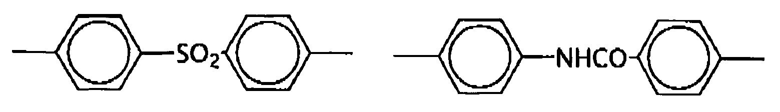

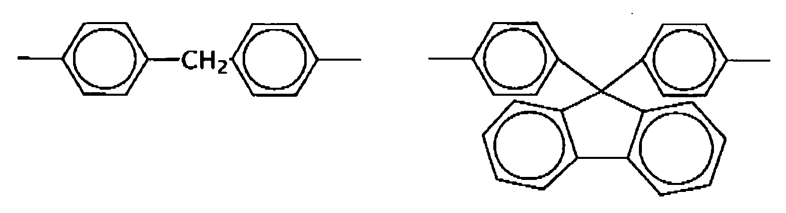

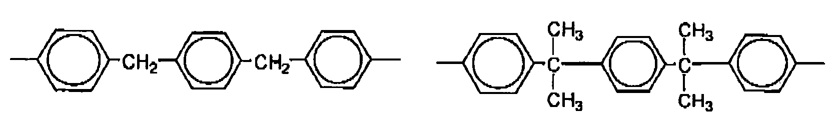

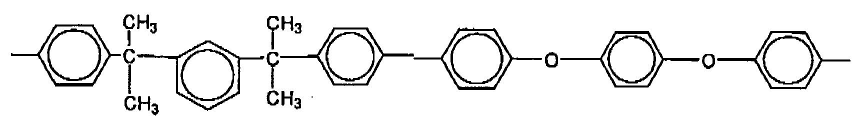

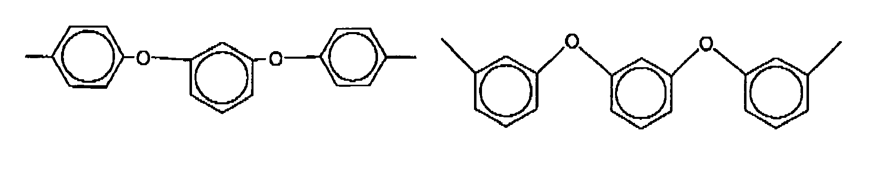

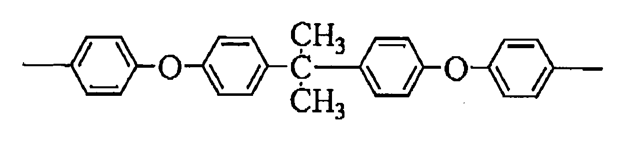

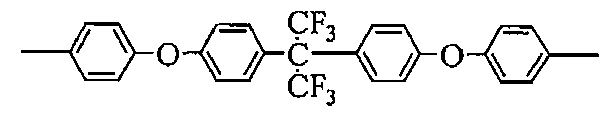

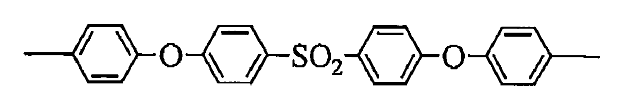

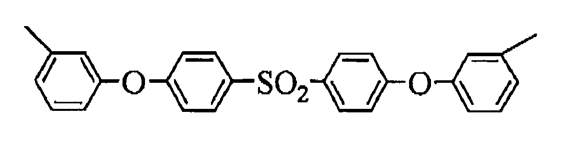

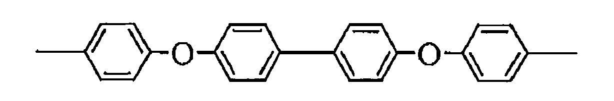

As noted herein above, in the formula (3), W is a divalent group represented by the following formula (5): 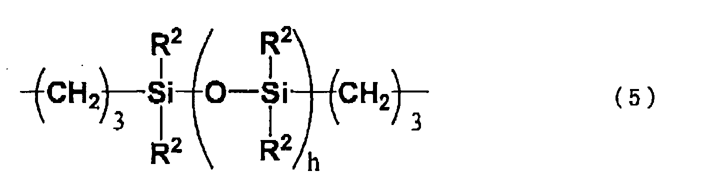 wherein, R² may be same as or different from each other and is a monovalent hydrocarbon group having from 1 to 8 carbon atoms, for example, an alkyl group such as a methyl group, an ethyl group, a propyl group, a butyl group, a pentyl group, or a hexyl group; a cycloalkyl group such as a cyclopentyl group or a cyclohexyl group; an aryl group such as a phenyl group; an aralkyl group such as a benzyl group or a phenethyl group; an alkenyl group such as a vinyl group, an allyl group, a propenyl group, an isopropenyl group, or a butenyl group; an acrylic group, and a methacrylic group. Preferred are a methyl group, an ethyl group, a phenyl group, and a vinyl group, because of good availability of raw materials thereof. In the formula (5), h is an integer of from 5 to 50.
In the formula (3), n preferably ranges from 3 to 400.
Another aspect of the present invention relates to a method of preparing the polyimide resin of the invention, said method comprising the steps of:
(1) reacting a diamine having a phenolic hydroxyl group with a tetracarboxylic acid dianhydride to prepare a polyamic acid,
(2) subjecting the polyamic acid to a dehydration and ring-closure reaction to prepare a polyimide resin having phenolic hydroxyl groups and consisting of three repeating units represented by the following formula (6), and
(3) reacting the polyimide with a 1,2-naphthoquinonediazidosulfonyl compound to replace at least a part of the hydrogen atoms of the phenolic hydoxyl groups of the polyimide with 1,2-naphthoquinonediazidosulfonyl groups, 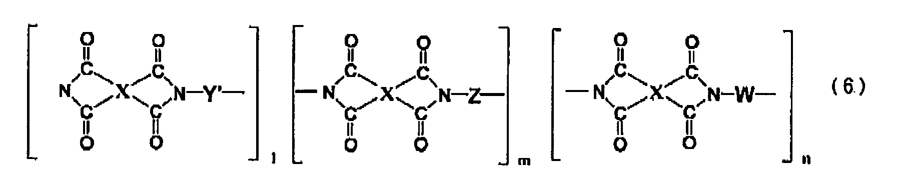
wherein X, Z, W, l, m and n are as defined above, and Y' is represented by the following formula (7): 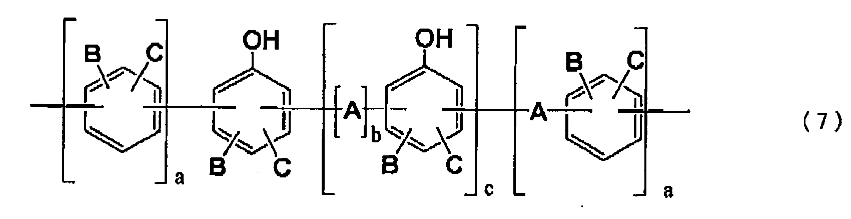 wherein A, B, C, a, b, and c are as defined above.
The present polyimide resin is photosensitive to a wide range of light wavelengths and the ratio of film thickness after a development process to original film thickness, hereinafter referred to as residual film ratio, is high. It is cured without being affected by oxygen. A cured film has strong adhesion to a substrate and good electrical insulation.

Examples of the tetracarboxylic acid dianhydride are as described above. Examples of diamine having phenolic hydroxyl groups include 3,3'-diamino-4,4'-dihydroxylbiphenyl, 2,2-diamino-4,4'-dihydroxybiphenyl, 2,2-bis(4-amino-3-hydroxylphenyl)propane, 2,2-bis(3-amino-4-hydroxylphenyl)propane, 9,9-bis(3-amino-4-hydroxylphenyl)fluorene, 2,2'-methylenebis[6-(4-amino-3,5-dimethylbenzyl)-4-methyl]phenol, 3,3'-diamino-4,4'-dihydroxydiphenylether, and 2, 2-bis(3-amino-4-hydroxylphenyl)hexafluoropropane.

To prepare the polyimide resin having m greater than 0, a diamine to derive Z is also used in the step (1). Examples of the diamine include 4,4'-diaminobenzanilide, 4,4'-diaminodiphenylether, 3,4'-diaminodiphenylether, 4,4'-diaminodiphenylsulphone, 3,3'-dimethyl-4,4'-diaminobiphenyl, 4,4'-(p-phenylenediisopropylidene)dianiline, 4,4'-(m-phenylenediisopropylidene)dianiline, 1,3-bis(4-aminophenoxy)benzene, 1,4-bis(4-aminophenoxy)benzene, 1,3-bis(3-aminophenoxy)benzene, 2,2-bis[4-(4-aminophenoxy)phenyl]propane, 2,2-bis[4-(4-aminophenoxy)phenyl]hexafluoropropane, bis[4-(4-aminophenoxy)phenyl]sulphone, bis[4-(3-aminophenoxy)phenyl]sulphone, 4,4'-bis(4-aminophenoxy)biphenyl, and 9,9-bis(4-aminophenyl)fluorene.

To prepare the polyimide resin having n greater than 0, a diaminosiloxane is used in the step (1) to derive W. The diaminosiloxane having the siloxane moiety represented by the aforesaid formula (5) with amino groups bonded to both ends thereof may be used.

In the preparation of the polyamic acid, a ratio of the diamine component(s) to the tetracarboxylic dianhydride component(s) may be selected according to an intended molecular weight of the polyimide and, in general, may be from 0.95 to 1.05, preferably from 0.98 to 1.02. In order to control the molecular weight of the polyimide, a mono-functional acid anhydride may be used such as phthalic anhydride or a mono-functional amine compound such as aniline. The mono-functional compound may be added preferably in an amount of 5 mole % or less, relative to the tetracarboxylic dianhydride component or the diamine component.

The reaction of the diamine with the acid dianhydride generally takes place in a solvent. As the solvent, any solvent that can dissolve the polyimide may be used. As specific examples of the solvent, mention may be made of ehters such as tetrahydrofuran and anisole; ketones such as cyclohexanone, 2-butanone, methylisobutylketone, 2-heptanone, 2-octanone, and acetophenone; esters such as butyl acetate, methyl benzoate, and gamma-butyrolactone; cellosolve acetates, such as butylcellosolve acetate, and propyleneglycol monomethylether acetate; amides, such as N,N-dimethylformamide, N,N-dimethylacetamide, and N-methyl-2-pyrrolidone; and aromatic hydrocarbons, such as toluene and xylene. Preferred are ketons, esters, and cellosolves, particularly gamma-butyrolactone, propyleneglycol monomethylether acetate, N,N-dimethylacetamide, and N-methyl-2-pyrrolidone. These solvents may be used alone or in combination of two or more of the solvents. Usually, the concentration of the polyimide is controlled in a range of from 10 to 40 weight %, taking account of yield per batch and solution viscosity.

In order to obtain the polyimide, a solution of the polyamic acid thus obtained is heated generally to a temperature of from 80 to 200 °C, preferably from 140 to 180 °C, or a mixture of acetic anhydride and pyridine is added to a solution of the polyamic acid, and then the resulting solution is heated to a temperature of about 50 °C to cause dehydration cyclization between an acid group and an amide group of the polyamic acid.

By adding a 1,2-quinonediazidosulfonyl compound and a basic compound to the polyimide resin solution thus obtained, an intended polyimide resin having 1,2-quinonediazidosulfonyl group can be obtained. Preferably, the 1,2-quinonediazidosulfonyl compound is 1,2-quinonediazido-4-sulfonyl chloride, 1,2-quinonediazido-5-sulfonyl chloride or a mixture thereof.

An amount of 1,2-quinonediazidosulfonyl chloride to be used is such that 2 to 25 mole %, preferably 5 to 20 mole% of hydroxyl groups of the polyimide resin are replaced with 1,2-quinonediazidosulfonyl groups. As described above, a resin having 1,2-naphthoquinonediazide sulfonyl groups more than the aforesaid upper limit may be too viscous to handle easily. A resin having 1,2-naphthoquinonediazide sulfonyl groups less than the aforesaid lower limit may not be suitable as a photosensitive resin.

Any basic compound can be used as far as it reacts with hydrogen chloride generated in the reaction to form salt and thereby promoting the reaction. Examples of the basic compounds include diethylamide and triethylamine.

Still another aspect of the present invention is a photosensitive composition comprising the aforesaid polyimide resin. The composition may further comprise any additive commonly incorporated in a photoresist composition in an amount not to adversely affect the properties of the composition. An example of the additives is a surfactant, preferably nonionic surfactant, e.g., a fluorinated surfactant such as perfluoroalkyl polyoxyethylene ethanol, fluorinated alkyl ester, perfluoroalkylamine oxide, and fluorinated organosiloxanes.

The fluorinated surfactants are commercially available, for example, Florard FC-4430 from Sumitomo 3M Ltd., Surflon S141, S145, both from Asahi Glass Co.Ltd., Unidine DS-401, DS-4031, and DS-451, all from Daikin Industries Ltd., Megafak F-8151 from Dainippon Ink & Chemicals, Inc., and X-70-093 from Shin-Etsu Chemical Co.Ltd, among which Florard FC-4430 and X-70-093 are preferred.

A silane coupling agent, e.g., an epoxy siloxane coupling agent such as the one sold under the trade name of KMB-403 from Shin-Etsu Chemical Co., Ltd., may be incorporated in the composition to improve adhesion of a heat cured film to a substrate.

A different photosensitive resin or a photosensitizer may be incorporated in the composition as needed to increase residual film ratio. For example, NT-300P, ex Toyo Gosei Co., Ltd., is preferably used as an agent to reduce solubility of the present polyimide resin in a developer and thereby improve the residual film ratio.

The present photosensitive composition may be prepared by mixing the aforesaid components, an organic solvent if needed, and optional additives while stirring and then filtering the mixture to remove any solid as needed.

The present composition thus prepared is suitable not only as a photoresist but also for preparing protective films of semiconductive devices and circuits.

Hence, the present invention also provides a method of forming a patterned layer by using the present polyimide resin, the method comprising the steps of:
(i) forming a layer comprising the present polyimide resin on a substrate,
(ii) exposing the layer on a substrate to a light having a wavelength of from 240 to 500 nm through a photomask having a pattern, and
(iii) dissolving the exposed part of the layer in an alkaline solution to develop the patterned layer.

In the step (i), the layer can be formed by applying on a substrate the present polyimide resin in the form of solution or film. Examples of the substrate include silicon wafer, plastic, metal and ceramic circuit boards.

Any method of application may be used such as dipping, spin coating and roll coating. The layer may have a thickness of from 0.1 to 100 µm.

Prior to the exposure step (ii), a solvent may be removed by heating the coated substrate to improve efficiency of photodecomposition in the development step (ii). The heating may be performed at a temperature of from 40 to 140 °C for 1 minute to 1 hour. Then, the coated substrate is exposed to actinic radiation having a wavelength of from 240 to 500 nm in any desired pattern using suitable masks, stencils, negatives, etc., made of chromium or quartz.

In another attractive embodiment of the present invention, the method of forming a patterned layer further comprises the steps of:
heating the layer at a temperature of from 40 to 140 °C for 0.5 to 10 minutes between the step (ii) and step (iii), and
heating the developed layer at a temperature of from 120 to 300 °C for 10 minutes to 10 hours after the step (iii).

The aforesaid light having a wavelength of from 240 to 500 nm may be UV light such as g-line, i-line, and far-UV light of 248 nm. Preferred exposure ranges from 10 to 2000 mJ/cm². After the exposure, heat may be applied to improve development sensitivity. This heating may be carried out at a temperature of from 40 to 140 °C for 0.5 to 10 minutes.

In the development step (iii), examples of alkaline compound used for the alkaline solution include inorganic alkaline compounds such as sodium hydroxide, potassium hydroxide, ammonium hydroxide, sodium carbonate, ammonium carbonate, sodium bicarbonate, potassium bicarbonate, and ammonium bicarbonate; organic alkaline compounds such as tetramethylammonium hydroxide, tetraethylammonium hydroxide, tetrapropylammonium hydroxide, N-methyldiethanolamine, N-ethyldiethanolamine, N,N-diethyldiethanolamine, triethanolamine, triisopropanolamine, and triisopropylamine, among which sodium carbonate, sodium bicarbonate and tetramethylammonium hydroxide are preferred. The concentration of the alkaline compound in water ranges from 0.1 to 20 wt%, preferably from 1 to 3 wt%. In addition to the alkaline aqueous solution, a small amount of water soluble organic solvent may be used such as methanol, ethanol, n-propanol, isopropanol, and N-methyl-2-pyrrolidone.

The coated substrate is immersed in the developing solution and then washed, rinsed and dried. A post-development heat treatment or bake may be employed at a temperature of from 120 to 300 °C for about 10 to 10 hours.

When patterning is not intended, e.g., coating or protective film making is intended, the applied polyimide resin in the step (i) is just heated in an oven or on a hotplate to a temperature of from 120 to 300 °C for about 10 minutes to 10 hours. The heat cured layer thus obtained has excellent adhesion to the substrate and electric property. The cured layer is suitable as protective layers for electric and electronic parts, semiconductive devices.

### EXAMPLES

The present invention will be explained with reference to the following Examples but not limited thereto.

### Example 1 (not within scope of appended claims)

In a flask equipped with a stirrer, a thermometer, and nitrogen purge equipment, were placed 31.0 g (0.1 mole) of 4,4'-oxydiphthalic dianhydride and 150 g of N-methyl-2-pyrrolidone. Subsequently, to the above-mentioned flask was added dropwise 25.8 g (0.1 mole) of 2,2'-bis(4-amino-3-hydroxylphenyl) propane dissolved in 100 g of N-methyl-2-pyrrolidone, while controlling the temperature of the reaction system at or below 50 °C. After the completion of the addition, the reaction mixture was further stirred at room temperature for 10 hours. Then, to the flask, a reflux condenser provided with a water receptor was attached and 70 g of xylene was added. Then, the temperature was raised to 150 °C. After keeping the temperature for 6 hours, a brown solution was obtained.

The brown solution thus obtained was cooled to room temperature of about 25 °C and then analyzed by IR spectroscopy and H-NMR spectroscopy. The IR absorption spectrum showed absorption bands at 1780 cm⁻¹ and 1720 cm⁻¹ of imide groups and 3400 cm⁻¹ of OH group, without absorption band of polyamic acid, and H-NMR spectrum showed a peak of phenolic OH group at 10 ppm, indicating the structure shown below:

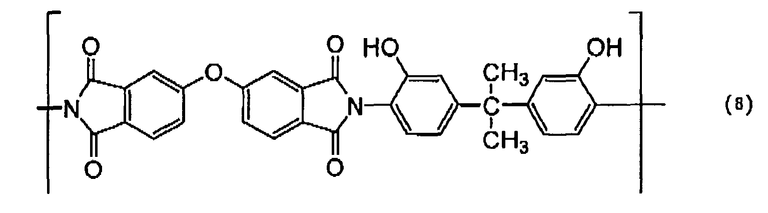

In a flask, 200 g of the obtained resin solution containing about 17% of resin, 3.43 g of 1,2-naphthoquinonediazido-5-sulfonyl chloride and 1.37 g of triethylamine were placed and stirred for 6 hours at room temperature. Then, a reaction mixture obtained was poured in 1 liter of methanol. Precipitated resin was filtered out, dried, and analyzed with H-NMR. Based on H-NMR peak of the C3 proton of 1,2-naphthoquinonediazido-5-sulfonyl group at 5.3 ppm and of the phenolic OH group at 10 ppm with its intensity smaller by about 10% from that observed for the resin of the above formula (8), it was found that the resin obtained, designated as A-1, had a repeating unit represented by the following formula: 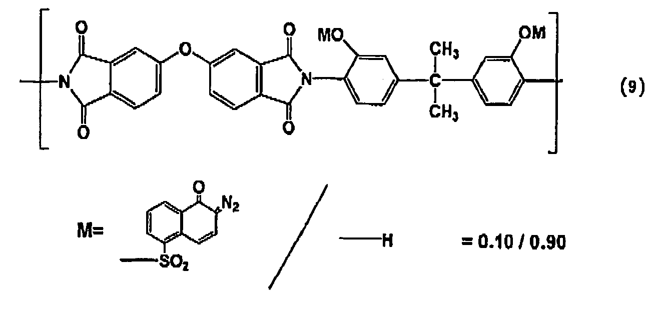 wherein 90% of M is a hydrogen atom and 10% of M is 1,2-naphthoquinonediazido-5-sulfonyl groups. The resin was found to have a number average molecular weight reduced to polystyrene of 59200 by gel permeation chromatography.

### Example 2

In a flask equipped with a stirrer, a thermometer, and nitrogen purge equipment, were placed 77.6 g (0.25 mole) of 4,4'-oxydiphthalic dianhydride, and 500 g of N,N-dimetylacetoamide. Subsequently, to the above-mentioned flask was added dropwise 51.7g (0.2 mole) of 2,2'-bis( 4-ammo-3-hydroxylphenyl) propane and 45.8 g(0.05 mole) of diaminosiloxane represented by the aforesaid formula (5) with h being 9 on average dissolved in 200 g of N,N-dimethylacetoamide, while controlling the temperature of the reaction system at or below 50 °C. After the completion of the addition, the reaction mixture was further stirred at room temperature for 10 hours. Then, to the flask, a reflux condenser provided with a water receptor was attached and 150 g of toluene was added. Then, the temperature was raised to 150 °C. After keeping the temperature for 6 hours, a brown solution was obtained.

The brown solution obtained was cooled to room temperature and thereby the resin solution containing about 20.6% of resin having phenolic hydroxyl groups was obtained. In a flask, 300 g of the resin solution, 3.98 g of 1,2-naphthoquinonediazido-5-sulfonyl chloride and 1.59 g of triethylamine were placed and stirred for 6 hours at room temperature. Then, a reaction mixture obtained was poured in 1 liter of methanol. Precipitated resin was filtered out and dried. The resin obtained, designated as A-4, was analyzed with H-NMR in the same manner as Example 1 to be found to have repeating units represented by the following formula: 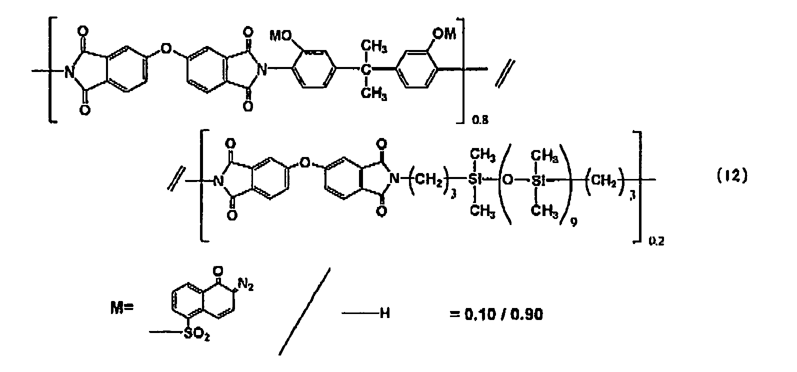 wherein 90% of M is a hydrogen atom and 10% of M is 1,2-naphthoquinonediazido-5-sulfonyl groups.
The resin was found to have a number average molecular weight of 63200 by gel permeation chromatography.

### Referential Example 1

A polyimide resin, designated as B-1, was obtained in the same manner as in Example 1 except that 20.59 g of 1,2-naphthoquinonediazido-5-sulfonyl chloride, and 8.20 g of triethylamine were used. The resin was analyzed by H-NMR in the same manner as in Example 1 to be found to have a repeating unit represented by the following formula: 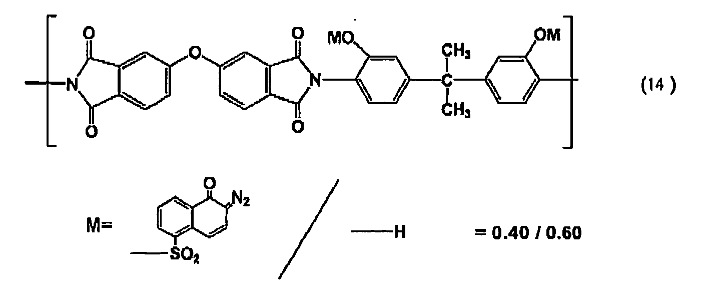 wherein 60% of M is a hydrogen atom and 40% of M is 1,2-naphthoquinonediazido-5-sulfonyl groups.
The resin was found to have a number average molecular weight of 73000 by gel permeation chromatography.

### Referential Example 2

A polyimide resin, designated as B-2, was obtained in the same manner as in Example 1 except that 0.51 g of 1,2-naphthoquinonediazido-5-sulfonyl chloride, and 0.20 g of triethylamine were used. The resin was analyzed by H-NMR in the same manner as in Example 1 to be found to have a repeating unit represented by the following formula: 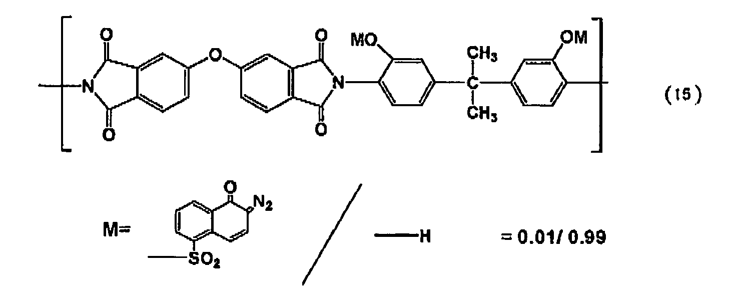 wherein 99% of M is a hydrogen atom and 1% of M is 1,2-naphthoquinonediazido-5-sulfonyl groups.
The resin was found to have a number average molecular weight of 54000 by gel permeation chromatography.

### Example 3, Referential Examples 3 & 4, Comparative Example 1

One hundred parts by weight of the polyimide resin prepared was dissolved in 400 parts by weight of cyclohexane, to which additive(s) in amount(s) in parts by weight described in Table 1 was were added and mixed, and thereby a photosensitive resin composition was obtained. For Comparative Example 1, the resin C-1 of the formula (8), which is a precursor of the resin A-1 was used.

Each composition was applied in a layer having a thickness described in Table 1 with a spin coater on three 15.24 cm (6-inch) silicon wafers each pretreated with hexamethyldisilazane, and a copper susbtrate mode by electrolytic platin copper on a silicon wafer.

### Photosensitive property

One of the coated silicon wafers was heated at 100 °C for 2 minutes on a hot plate to remove the solvent. Then, the dried layer of the composition was exposed to the light with the exposure described in Table 1 through a quartz photomask having striped patterns of line/space ratio of 1/1 with a line width ranging from 1 to 20 µm in 1 µm increment, 5 lines for each width. In Table 1, NSR-1755i7A is a stepper-type exposure equipment manufactured by Nikon Corp., and PLA-600FA is a contact aligner type exposure equipment manufactured by Canon Inc. After the exposure, the composition layer was heated at a temperature of 80 °C for 1 minute and then cooled.

Then, the substrate with the composition layer thereon was immersed in a 2.38 wt% aqueous solution of tetramethylammonium hydroxide for 3 minutes to develop the pattern. The minimum line width resolved and the thickness of the layer after development are as shown in Table 1.

### Adhesive property

The second coated silicon wafer and the copper substrate were treated in the same manner as above till the development except that a quartz photomask having a striped pattern with line/space of 20µm/20µm was used. The striped form of layer obtained was heated in an oven at 200 °C for 3 hours and then in a pressure cooker at 2 atmospheric pressure with water vapor for 24 hours. The layer taken out of the pressure cooker was visually inspected for any peeled stripes. The results are as shown in Table 2, wherein "None" means that there were no peeled stripes.

### Electric insulation property

The third coated silicon wafer was heated at 100 °C for 2 minutes on a hot plate to remove the solvent, and then 200°C for 3 hours in an oven. The layer obtained was subjected to an electrical breakdown test according to ASTM D149.

**Table 1**

| | Components | | Applied Thickness µm | Exposure | Developed Thickness, µm | Resolution, µm |
|---|---|---|---|---|---|---|
| | Resin-parts | Additives, parts | | | | |
| Example 3 | | X-70-093 | 6.4 | NSR-175517A NSR-1755i7A | 6.3 | 5 |
| | A-4 | 0.02 | | 365nm/ | | |
| | 100 | KBE-403 | | 300mJ/cm² | | |
| | | 0.1 | | | | |
| Referential Example 3 | | X-70-093 | - | - | - | - |
| | B-1 | 0.02 | | | | |
| | 100 | KBE-403 | | | | |
| | | 0.1 | | | | |
| Referential Example 4 | | X-70-093 | 6.2 | NSR-1755i7A | 0 | - |
| | B-2 | 0.02 | | 365nm/ | | |
| | 100 | KBE-403 | | 300mJ/cm² | | |
| | | 0.1 | | | | |
| Comparative Example 1 | | X-70-093 | 6.1 | NSR-1755i7A | 0 | - |
| | C-1 | 0.02 | | 365nm/ | | |
| | 100 | NT-300P | | 300mJ/cm² | | |
| | | 10 | | | | |

| | | | | | | |
|---|---|---|---|---|---|---|
| KBE-403: an adhesive, ex Shin-Etsu Chemical Co., Ltd. X-70-093: a surfactant, ex Shin-Etsu Chemical Co., Ltd. NT-300P: a photosensitizer, ex Toyo Gosei Co., Ltd. | | | | | | |

**Table 2**

| Example | Adhesion | | Electrical breakdown |
|---|---|---|---|
| | Silicon wafer | Copper substrate | |
| Example 3 | None | None | 250V/µm |

In Table 1, the composition of Referential Example 1 could not be applied with the spin coater due to a high viscosity. The compositions of Referential Example 2 and Comparative Example 1 dissolved in the developing solution. In contrast, the present composition showed good residual film ratio and resolution. The heat-cured film of the present resin had good adhesion and electrical insulation. The present resin is therefore suitable as a photoresist and a protective film.

## Claims

1. A polyimide resin having a number average molecular weight of from 2,000 to 800,000, said resin consisting of the three repeating units represented by the following formula (3): 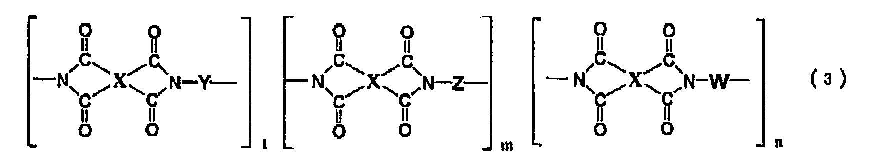 wherein X is a tetravalent organic group,
Y is a divalent organic group represented by the following formula (2): 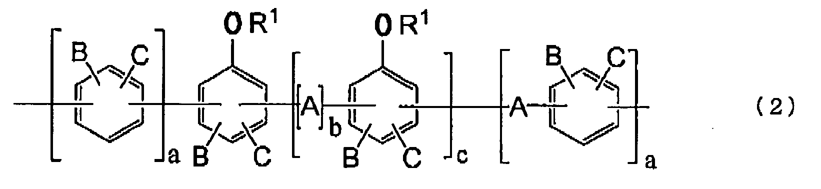 wherein A may be the same as or different from each other and is a divalent organic group selected from the following groups: 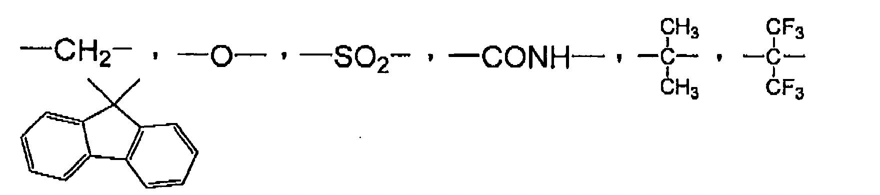 B and C may be the same or different from each other and are selected from the group consisting of a hydrogen atom and alkyl groups having 1 to 4 carbon atoms, a is 0 or 1, c is an integer of from 0 to 10, b is 0 or 1, 75 to 98 mole % of R¹ is a hydrogen atom, and 2 to 25 mole % of R¹ is 1,2-naphthoquinonediazide sulfonyl group,
W is a divalent organic group represented by the following formula (5): 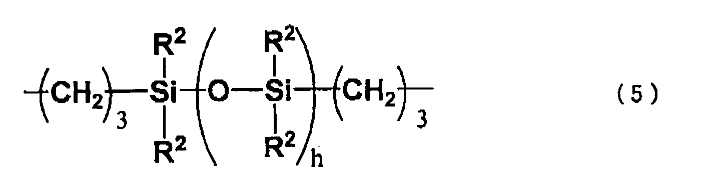 wherein R² may be the same as or different from each other and is a monovalent hydrocarbon group having 1 to 8 carbon atoms and h is an integer of from 5 to 50,
Z is a divalent organic group other than Y and W,
l is a positive integer, and m and n are integers of 0 or larger with 0.1 ≤ l/(l+m+n)<1, 0 < m/(l+m+n) ≤ 0.8, and 0 < n/(l+m+n) ≤ 0.8.

2. The polyimide resin according to claim 1, wherein 1,2-naphthoquinonediazide sulfonyl group is 1,2-naphthoquinonediazide-4-sulfonyl group or 1,2-naphthoquinonediazide-5-sulfonyl group.

3. The polyimide resin according to claim 1 or 2, wherein X is at least one selected from the following groups.

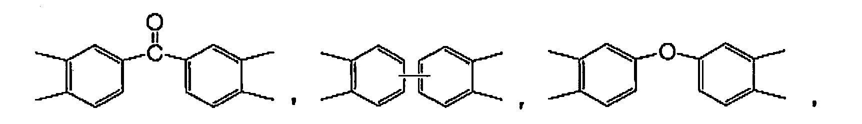

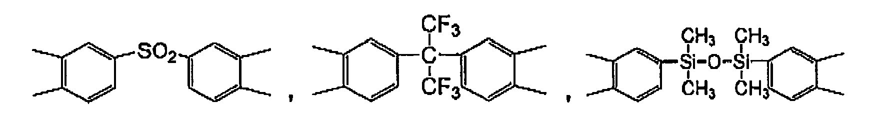

4. The polyimide resin according to any one of claims 1 to 3, wherein Z is represented by the following formula (4): 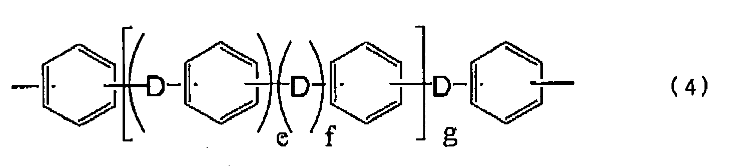 wherein D may be the same as or different from each other and is a divalent organic group selected from the following groups, 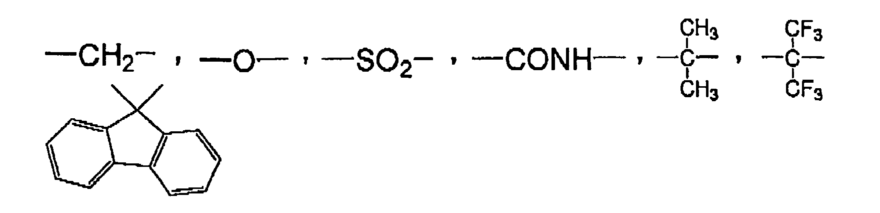 g is 0 or 1, and e and f are 0 or 1.

5. The polyimide resin according to any one of claims 1 to 4, wherein n in the formula (3) ranges from 3 to 400.

6. A method of preparing the polyimide resin according to any one of claims 1 to 5, comprising the steps of
(1) reacting a diamine having a phenolic hydroxyl group with a tetracarboxylic acid dianhydride to prepare a polyamic acid,
(2) subjecting the polyamic acid to a dehydration and ring-closure reaction to prepare a polyimide resin having phenolic hydroxyl groups and consisting of three repeating units represented by the following formula (6), and
(3) reacting the polyimide with a 1,2-naphthoquinonediazidosulfonyl compound to replace at least a part of the hydrogen atoms of the phenolic hydoxyl groups of the polyimide with 1,2-naphthoquinonediazidosulfonyl group, 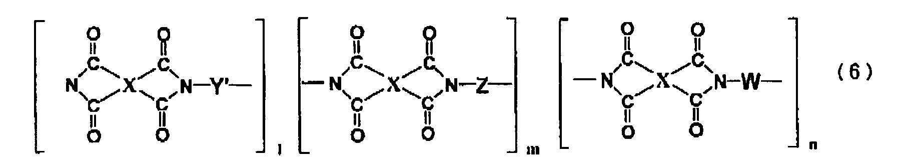
wherein X, Z, W, l, m and n are as defined above, and Y' is a divalent organic group represented by the following formula (7): 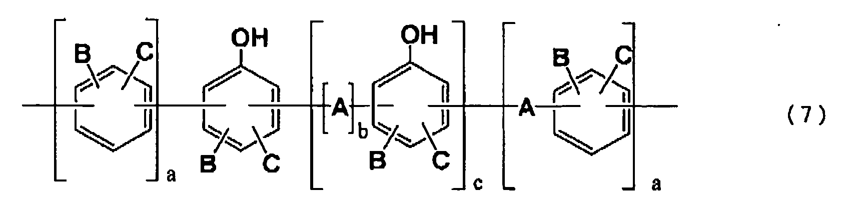 wherein A, B, C, a, b, and c are as defined above.

7. A photosensitive resin composition comprising the polyimide resin according to any one of claims 1 to 5.

8. A method of forming a patterned layer comprising the steps of
(i) forming a layer comprising the polyimide resin according to any one of claims 1 to 5 on a substrate,
(ii) exposing the layer on the substrate to a light having a wavelength of from 240 to 500 nm through a photomask having a pattern,
(iii) dissolving the exposed part of the layer in an alkaline solution to develop the patterned layer.

9. The method according to claim 8, wherein the method further comprises the steps of:
heating the layer at a temperature of from 40 to 140 °C for 0.5 to 10 minutes between the step (ii) and step (iii), and
heating the developed layer at a temperature of from 120 to 300 °C for 10 minutes to 10 hours after the step (iii).

## Patentansprüche

1. Polyimidharz mit einer zahlengemittelten Molekülmasse von 2.000 bis 800.000, wobei das Harz aus den drei durch die folgende Formel (3) dargestellten Wiederholungseinheiten besteht: 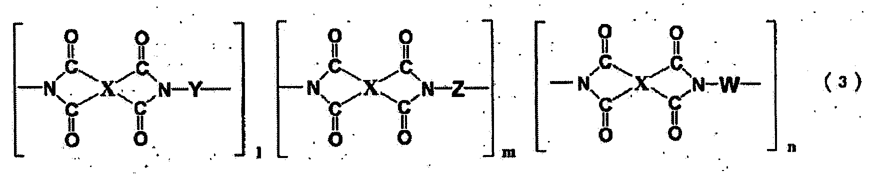 wobei X eine tetravalente organische Gruppe ist,
Y eine durch die folgende Formel (2) dargestellte divalente organische Gruppe ist: 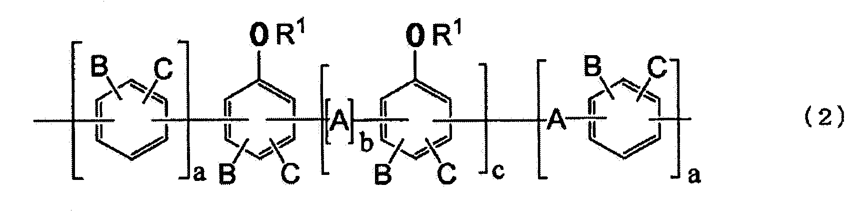 wobei A gleich oder unterschiedlich voneinander sein können und eine aus den folgenden Gruppen ausgewählte divalente organische Gruppe ist: 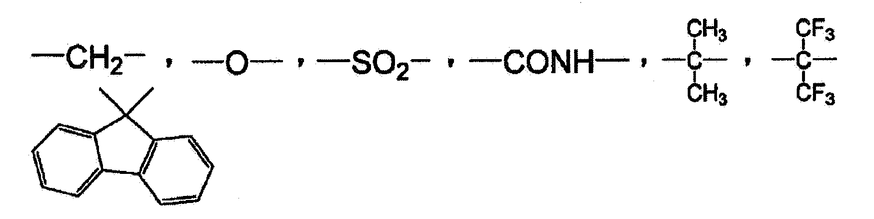 B und C können gleich oder unterschiedlich voneinander sein und sind ausgewählt aus der Gruppe bestehend aus einem Wasserstoffatom und Alkylgruppen mit 1 bis 4 Kohlenstoffatomen, a ist 0 oder 1, c ist eine ganze Zahl von 0 bis 10, b ist 0 oder 1, 75 bis 98 Mol-% von R¹ ist ein Wasserstoffatom, und 2 bis 25 Mol-% von R¹ ist eine 1,2-Naphtoquinondiazidsulfonylgruppe;
W eine durch die folgende Formel (5) dargestellte divalente organische Gruppe ist: 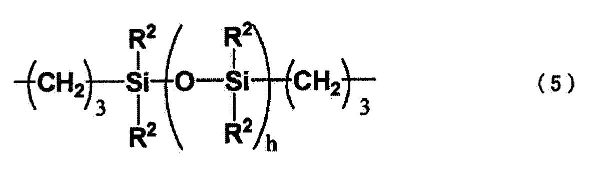 wobei R² gleich oder unterschiedlich voneinander sein können und eine monovalente Kohlenwasserstoffgruppe mit 1 bis 8 Kohlenstoffatomen ist und h eine ganze Zahl von 5 bis 50 ist,
Z eine andere divalente organische Gruppe als Y und W ist,
1 eine positive ganze Zahl ist, und m und n ganze Zahlen von 0 oder größer mit 0,1 ≤ l/(l+m+n) < 1, 0 < m/(l+m+n) ≤ 0,8, und 0 < n/(l+m+n) ≤0,8 sind.

2. Polyimidharz nach Anspruch 1, wobei 1,2-Naphtoquinondiazidsulfonylgruppe eine 1,2-Naphtoquinondiazid-4-sulfonylgruppe oder eine 1,2-Naphtoquinondiazid-5-sulfonylgruppe ist.

3. Polyimidharz nach Anspruch 1 oder 2, wobei X zumindest Eine ist, die aus den folgenden Gruppen ausgewählt ist.

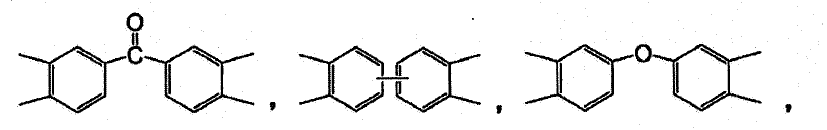

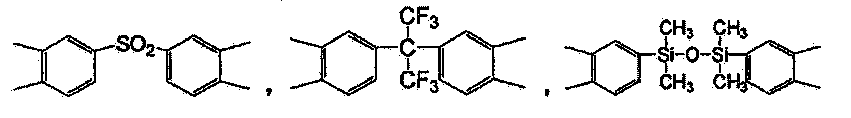

4. Polyimidharz nach einem der Ansprüche 1 bis 3, wobei Z durch die folgende Formel (4) dargestellt ist: 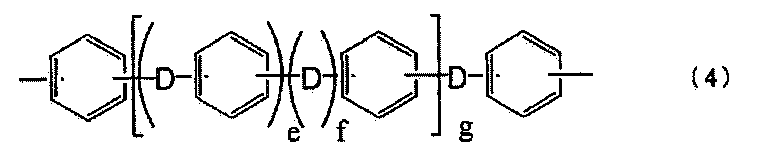 wobei D gleich oder unterschiedlich voneinander sein können und eine aus den folgenden Gruppen ausgewählte divalente organische Gruppe ist, 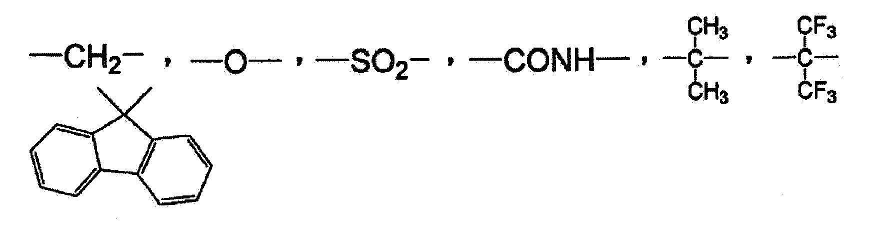 g ist 0 oder 1, und e und f sind 0 oder 1.

5. Polyimidharz nach einem der Ansprüche 1 bis 4, wobei n in der Formel (3) von 3 bis 400 reicht.

6. Verfahren zum Herstellen des Polyimidharzes nach einem der Ansprüche 1 bis 5, das die Schritte umfasst
(1) Reagieren eines Diamins, das eine phenolische Hydroxylgruppe aufweist, mit einem Tetracarbonsäuredianhydrid, um eine Polyamidsäure herzustellen,
(2) Unterwerfen der Polyamidsäure einer Dehydratation und Ringschlussreaktion, um ein Polyimidharz herzustellen, das phenolische Hydroxylgruppen aufweist und aus drei durch die folgende Formel (6) dargestellten Wiederholungseinheiten besteht, und
(3) Reagieren des Polyimids mit einer 1,2-Naphtoquinondiazidosulfonylverbindung, um zumindest einen Teil der Wasserstoffatome der phenolischen Hydroxylgruppen des Polyimids mit 1,2-Naphtoquinondiazidosulfonylgruppen zu ersetzen, 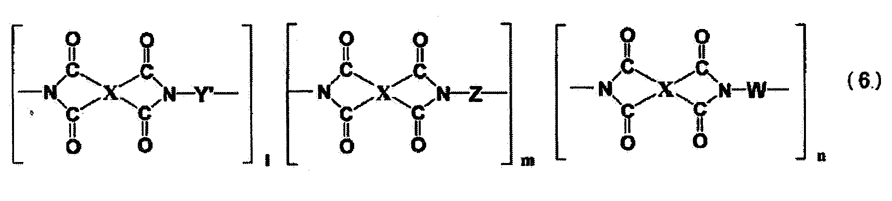
wobei X, Z, W, l, m und n wie oben definiert sind und Y' eine durch die folgende Formel (7) dargestellte divalente organische Gruppe ist: 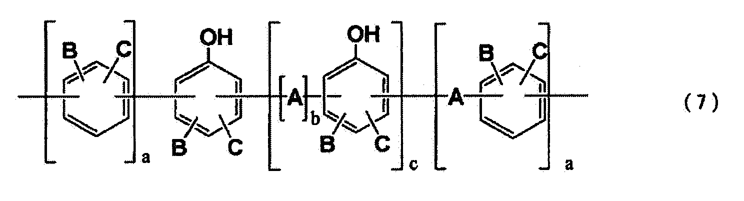 wobei A, B, C, a, b und c wie oben definiert sind.

7. Photosensitive Harzzusammensetzung, die das Polyimidharz nach einem der Ansprüche 1 bis 5 umfasst.

8. Verfahren zum Herstellen einer gemusterten Schicht, das die Schritte umfasst
(i) Bilden einer Schicht, die das Polyimidharz nach einem der Ansprüche 1 bis 5 umfasst, auf einem Substrat,
(ii) Belichten der Schicht auf dem Substrat mit Licht einer Wellenlänge von 240 bis 500 nm durch eine Photomaske mit einem Muster,
(iii) Auflösen des belichteten Teils der Schicht in einer alkalischen Lösung, um die gemusterte Schicht zu entwickeln.

9. Verfahren nach Anspruch 8, wobei das Verfahren ferner die Schritte umfasst:
Erwärmen der Schicht zwischen dem Schritt (ii) und dem Schritt (iii) bei einer Temperatur von 40 bis 140°C für 0,5 bis 10 Minuten, und
Erwärmen der entwickelten Schicht nach dem Schritt (iii) bei einer Temperatur von 120 bis 300°C für 10 Minuten bis 10 Stunden.

## Revendications

1. Résine de polyimide ayant un poids moléculaire moyen en nombre de 2000 à 800 000, ladite résine étant constituée de trois unités récurrentes représentées par la formule (3) suivante : 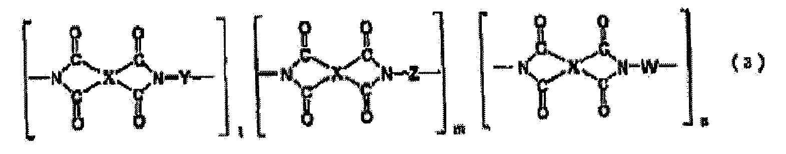 dans laquelle X est un groupement organique tétravalent,
Y est un groupement organique divalent représenté par la formule (2) suivante : 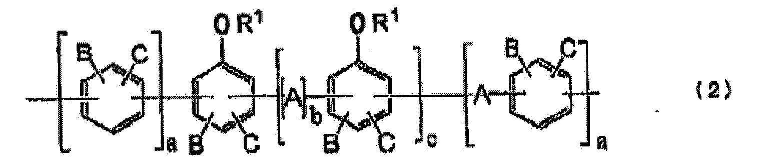 dans laquelle l'entité A peut être identique ou différente et représente un groupement organique divalent choisi parmi les groupements suivants : 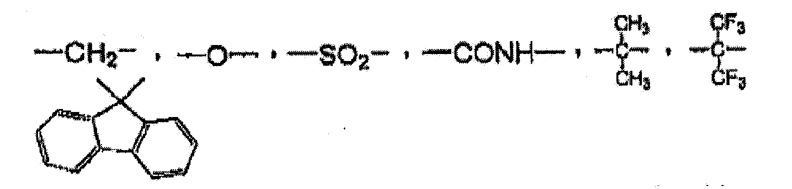 Les entités B et C peuvent être identiques ou différentes l'un de l'autre et sont choisies dans le groupe constitué d'un atome d'hydrogène et de groupements alkyle présentant 1 à 4 atomes de carbone, a vaut 0 ou 1, c est un nombre entier de 0 à 10, b vaut 0 ou 1, 75 à 98 % en mole de R¹ sont représentés par un atome d'hydrogène et 2 à 25 % en mole de R¹ sont représentés par un groupement 1,2-naphtoquinonediazide-sulfonyle,
W est un groupement organique divalent représenté par la formule (5) suivante : 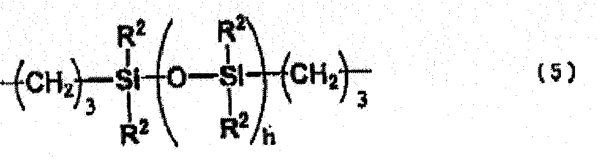 dans laquelle R² peut être identique ou différent et représente un groupement hydrocarboné monovalent ayant 1 à 8 atomes de carbone et h est un entier de 5 à 50,
Z est un groupement organique divalent différent de Y et de W,
1 est un nombre entier positif et m et n sont des nombres entiers valant 0 ou plus répondant aux relations 0,1 ≤ l/(l+m+n) < 1,0 < m/(l+m+n) ≤ 0,8 et 0 < n/(l+m+n) ≤ 0,8.

2. Résine de polyimide selon la revendication 1, dans laquelle le groupement 1,2-naphtoquinonediazide-sulfonyle est un groupement 1,2-naphtoquinonediazide-4-sulfonyle ou un groupement 1,2-naphtoquinonediazide-5-sulfonyle.

3. Résine de polyimide selon la revendication 1 ou 2, dans laquelle X est au moins un groupement choisi parmi les groupements suivants :

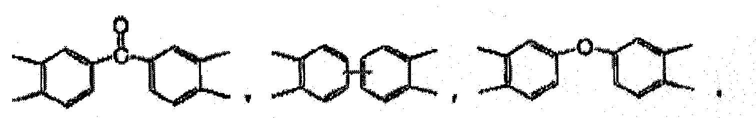

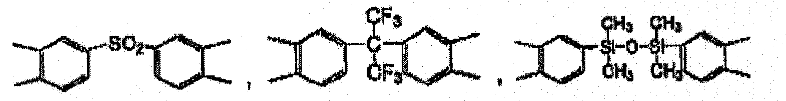

4. Résine de polyimide selon la revendication 1 à 3, dans laquelle Z est représenté par la formule (4) suivante : 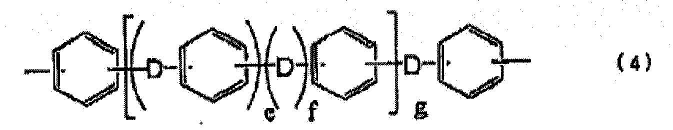 dans laquelle D peut être identique ou différent et représente un groupement organique divalent choisi parmi les groupements suivants : 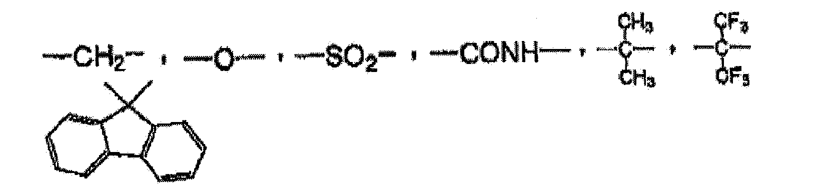 g vaut 0 ou 1 et e et f valent 0 ou 1.

5. Résine de polyimide selon l'une quelconque des revendications 1 à 4, dans laquelle n dans la formule (3) se situe dans la plage de 3 à 400.

6. Procédé de préparation de la résine de polyimide selon l'une quelconque des revendications 1 à 5, comprenant les étapes consistant à :
(1) faire réagir une diamine présentant un groupement hydroxyle phénolique avec un dianhydride d'acide tétracarboxylique dans le but de préparer un acide polyamique.
(2) soumettre l'acide polyamique à une déshydratation et à une réaction de fermeture de cycle en vue de préparer une résine de polyimide présentant des groupements hydroxyle phénolique et constituée de trois unités récurrentes représentées par la formule (6) suivante, et
(3) faire réagir le polyimide avec un composé de 1,2-naphtoquinonediazido-sulfonyle dans le but de remplacer au moins une partie des atomes d'hydrogène des groupements hydroxyle phénolique du polyimide par un groupement 1,2-naphtoquinone-diazido-sulfonyle 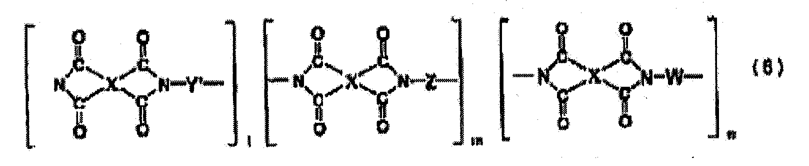
dans laquelle X, Z, W, 1, m et n sont tels que définis ci-dessus et Y' est un groupement organique divalent représenté par la formule (7) suivante : 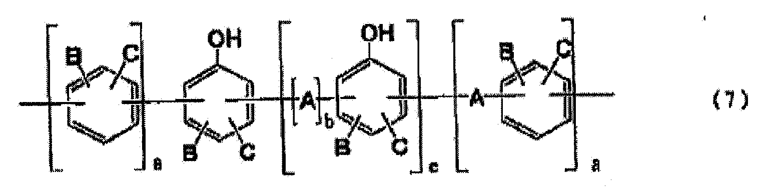 dans laquelle A, B, C, a, b et c sont tels que définis ci-dessus.

7. Composition de résine photosensible comprenant la résine de polyimide selon l'une quelconque des revendications 1 à 5.

8. Procédé de formation d'une couche configurée comprenant les étapes consistant à :
(i) former une couche comprenant la résine de polyimide selon l'une quelconque des revendications 1 à 5 sur un substrat,
(ii) exposer la couche sur le substrat à une lumière d'une longueur d'onde dans la plage de 240 à 500 nm à travers un photomasque présentant un motif,
(iii) dissoudre la partie exposée de la couche dans une solution alcaline en vue de développer la couche configurée.

9. Procédé selon la revendication 8, dans lequel le procédé comprend en outre les étapes consistant à :
chauffer la couche à une température de 40 à 140 °C pendant 0,5 à 10 minutes entre l'étape (ii) et l'étape (iii), et
chauffer la couche développée à une température de 120 à 300 °C pendant 10 minutes à 10 heures après l'étape (iii).
